# EUROPÄISCHE PATENTSCHRIFT

(11) **EP 2 318 687 B1**
(45) Veröffentlichungstag und Bekanntmachung des Hinweises auf die Patenterteilung: **14.03.2012**
(21) Anmeldenummer: 09702549.8
(22) Anmeldetag: 09.01.2009
(51) Int. Cl.: F02M 51/02, H01L 41/083

(54) **PIEZOELEKTRISCHER AKTOR**
PIEZOELECTRIC ACTUATOR
ACTIONNEUR PIÉZOÉLECTRIQUE

(30) Priorität: 14.01.2008 DE 102008004204; 08.01.2009 DE 102009000089
(43) Veröffentlichungstag der Anmeldung: 11.05.2011
(73) Patentinhaber: Robert Bosch GmbH, 70442 Stuttgart (DE)
(72) Erfinder: REISS, Juergen, 71254 Ditzingen (DE); DEROMELAERE, Gaetan, 70806 Kornwestheim (DE); POLSTER, Steffen, 70199 Stuttgart (DE); GRAF, Anja, 71691 Freiberg/Neckar (DE); ESCHENBACHER, Cosima, 91623 Sachsen B. Ansbach (DE); HEJTMANN, Georg, 74395 Mundelsheim (DE); FELTEN, Frank, 76137 Karlsruhe (DE); HENNECK, Stefan, 71229 Leonberg (DE); KONSTANDIN, Alexander, 74862 Binau (DE)
(86) Internationale Anmeldenummer: PCT/EP2009/050203
(87) Internationale Veröffentlichungsnummer: WO 2009/090142

(56) Entgegenhaltungen:
- EP-A- 1 764 844
- WO-A-03/105246
- DE-A1-102005 057 767
- US-A1- 2007 124 903

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 10 2005 057 767 A1 ist ein piezoelektrisches Element bekannt. Das bekannte piezoelektrische Element ist dabei als hohles, laminiertes piezoelektrisches Element ausgestaltet. Dieses weist ein Keramiklaminat auf, das durch alternierende Beschichtung von piezoelektrischen Schichten und internen Elektrodenschichten mit Leitfähigkeit gebildet wird. Ferner ist eine mittlere Durchgangsöffnung in dem Element vorgesehen, die so ausgebildet ist, dass sie durch das Keramiklaminat entlang einer Laminierungsrichtung verläuft. Das Keramiklaminat hat am Innenumfang eine intern abgeschlossene Struktur, wobei ein Abschnitt der Innenumfangsenden der Elektrodenschichten nicht der Innenumfangsfläche des Keramiklaminats ausgesetzt ist. Die Innenumfangsfläche des Keramiklaminats hat Innenumfangsschlitze mit Einschnitten, die in die umlaufende Richtung von der Innenumfangsfläche hin zur Innenseite der piezoelektrischen Schichten bereitgestellt sind.

Das aus der DE 10 2005 057 767 A1 bekannte piezoelektrische Element hat mehrere Nachteile. Durch die Innenumfangsschlitze mit Einschnitten kommt es zu einer häufigen Unterbrechung der Innenumfangsfläche des Keramiklaminats, so dass die Herstellung entsprechend aufwendig ist. Beispielsweise kann es während eines Schleifprozesses zu Verschmutzungen kommen, die sich in den Innenumfangsschlitzen festsetzen. Dies macht gegebenenfalls einen aufwendigen Reinigungsprozess erforderlich. Ferner kann es durch die häufige Unterbrechung der Innenumfangsfläche des Keramiklaminats während der Herstellung leicht zu Beschädigungen im Bereich der Innenumfangsfläche, beispielsweise durch Ausbrechen, kommen. Ein weiterer Nachteil besteht darin, dass bis zu dem Querschnitt des Keramiklaminats, in dem sich die Innenumfangsschlitze erstrecken, keine Elektrodenschichten vorgesehen sind, so dass der piezoelektrisch wirksame Teil des Keramiklaminats verringert ist. Die aus der DE 10 2005 057 767 A1 bekannte Lösung, die das Auftreten von Rissen durch Entlastungsstrukturen verhindern soll, wirkt sich deshalb ungünstig auf die eigentliche Funktion des piezoelektrischen Elements aus.

In US 2007/0124903 A1 ist ein piezoelektrisches Element mit Hohlräumen offenbart, wobei die Hohlräume eine definierte Rissausbildung in dem piezoelektrischen Element gewährleisten.

### Offenbarung der Erfindung

### Vorteilhafte Wirkungen

Der erfindungsgemäße piezoelektrische Aktor mit den Merkmalen des Anspruchs 1 und das erfindungsgemäße Brennstoffeinspritzventil mit den Merkmalen des Anspruchs 11 haben demgegenüber den Vorteil, dass eine hohe Zuverlässigkeit des piezoelektrischen Aktors bei einer hohen Funktionsfähigkeit gewährleistet ist.

Durch die in den Unteransprüchen aufgeführten Maßnahmen sind vorteilhafte Weiterbildungen des im Anspruch 1 angegebenen piezoelektrischen Aktors und des im Anspruch 11 angegebenen Brennstoffeinspritzventils möglich.

In vorteilhafter Weise kann durch die Hohlräume innerhalb des Aktorkörpers eine Entlastung für Zugspannungen im Aktorkörper geschaffen werden. Die Ausbildung dieser Hohlräume kann durch eine Ausbrandstruktur realisiert werden, die während eines Laminierungsprozesses ausgestaltet wird und bei einem Sinterprozess und dergleichen ausbrennt, um die Hohlräume zu schaffen. Dadurch können an definierten Stellen innerhalb des Aktorkörpers solche Hohlräume platziert werden, insbesondere im Bereich großer erwarteter Zugspannungen. Vorteilhaft ist es, dass der Aktorkörper mehrere Hohlräume aufweist und dass Spannungsrisse innerhalb des Aktorkörpers zumindest im Wesentlichen von einem oder den mehreren Hohlräumen ausgehen. Durch die Kerbwirkung des Hohlraums beziehungsweise der Hohlräume erhöhen sich die Zugspannungen lokal im verbleibenden Bereich des Aktorkörpers neben den Hohlräumen, insbesondere in einem passiven Bereich, was schließlich zu einer Rissbildung am Aktormantel führt. Durch die Rissbildung können die Zugspannungen im Bereich des Hohlraums vollständig abgebaut werden. Diese bauen sich erst in den vom Hohlraum entfernten Schichten wieder auf. Durch die Anordnung der Hohlräume über dem Aktorkörper ist es möglich, die Spannungen bereichsweise gezielt auf ein für weitere Rissbildungen unkritisches Niveau zu reduzieren, so dass Spannungsrisse im Wesentlichen von dem einen oder den mehreren Hohlräumen ausgehen. Dabei ist es ferner vorteilhaft, dass die Hohlräume zwischen zwei gleichgeschalteten Elektrodenschichten vorgesehen sind. Dies hat den Vorteil, dass die Rissauslösung und Rissbildung in einem weitgehend feldfreien Bereich erfolgt, der im Betrieb geringeren Belastungen ausgesetzt ist und insbesondere nicht zur dynamischen Wirkung beiträgt.

Vorteilhaft ist es, dass die Hohlräume als im wesentlichen vollständig oder teilweise ausgebrannter Hohlraum ausgebildet sind und dass der Aktorkörper zumindest eine Öffnung aufweist, über die ein Hohlraum mit einer Umgebung des Aktorkörpers verbunden ist. Dabei erleichtert die Öffnung das Ausbrennen der Ausbrandstruktur während eines Sinterprozesses oder dergleichen zur Ausbildung des ausgebrannten Hohlraums, da die Öffnung beim Ausbrennen den Abtransport der Substanz, welche den Hohlraum hinterlässt, unterstützt. Die Anzahl und Größe der Öffnungen ist dabei vorzugsweise so gewählt, dass ein zuverlässiger Abtransport dieser Substanz beim Ausbrennen gewährleistet ist, ohne dass es zu einer übermäßigen Unterbrechung der Oberfläche des Aktorkörpers durch die Öffnungen kommt.

Vorteilhaft ist es auch, dass die Hohlräume zumindest teilweise mit einer porösen keramischen Struktur gefüllt sind. Solch eine als Füllung oder Teilfüllung für die Hohlräume dienende poröse keramische Struktur kann sich positiv auf ein mögliches Rissverhalten im Aktorkörper auswirken.

Innerhalb des Aktorkörpers sind ein erster Hohlraum und ein zweiter Hohlraum ausgebildet, die zumindest näherungsweise in einer Querschnittsebene liegen, und der erste Hohlraum ist von dem zweiten Hohlraum durch einen keramischen Bereich der keramischen Schicht getrennt. Durch diese zwei voneinander getrennten Geometrien, die in einer Ebene liegen, kann erreicht werden, dass entstehende Risse effektiv in eine gewünschte Richtung und Ebene gelenkt werden und weniger dazu neigen, sich zu verzweigen, beziehungsweise dass der Rissfortlauf definiert gestoppt wird. Zusätzlich bietet der tragende keramische Bereich zwischen den zwei die Hohlräume erzeugenden Geometrien den Vorteil, dass eine Steifigkeit des Aktors im Vergleich zu einem entsprechendem einzelnen Hohlraum erhöht ist.

Der keramische Bereich ist vorzugsweise als tragender keramischer Bereich ausgestaltet, der eine weitgehend beliebige Ausgestaltung, insbesondere Größe, haben kann. In vorteilhafter Weise ist der keramische Bereich als keramischer Steg zwischen den Hohlräumen ausgestaltet. Erfindungsgemäß sind die Hohlräume ringförmig ausgestaltet, wobei der ringförmige zweite Hohlraum innerhalb des ringförmigen ersten Hohlraums angeordnet ist.

Vorteilhaft ist es, dass der erste Hohlraum näher an der Oberfläche angeordnet ist als der zweite Hohlraum, dass der erste Hohlraum die gezielte Ausbildung des Risses von dem ersten Hohlraum zu der Oberfläche ermöglicht und dass der zweite Hohlraum bei der gezielten Ausbildung des Risses von dem ersten Hohlraum zu der Oberfläche zum Stoppen einer möglichen zusätzlichen Ausdehnung des Risses in eine keramische Schicht dient. Der äußere Hohlraum sorgt hierbei in einem Zug-Spannungsbereich für eine schnelle und gezielte Rissbildung. Der innere Hohlraum dient zur Richtungsvorgabe und zum Stopp der Rissausbreitung in Richtung des Inneren des Aktorkörpers, insbesondere des aktiven Aktorbereichs. Hierdurch kann eine gezielte Rissbildung erfolgen. Die minimale Anzahl der über die Aktorlänge verteilten Hohlräume, insbesondere Ausbrandstrukturen, ist so gewählt, dass keine zusätzlichen natürlichen Risse während des Betriebes mehr entstehen oder zumindest eine Entstehung zusätzlicher Risse erheblich reduziert ist. Die maximale Anzahl solcher Hohlräume ist dadurch gegeben, dass bei der Inbetriebnahme eine Rissbildung bzw. ein Aufreißen an allen Hohlräumen bzw. Ausbrandstrukturen erfolgt.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Ausführungsbeispiel eines Brennstoffeinspritzventils mit einem piezoelektrischen Aktor in einer schematischen, axialen Schnittdarstellung;
Fig. 2A einen Schnitt durch den in Fig. 1 dargestellten Aktorkörper des piezoelektrischen Aktors entlang der mit II bezeichneten Schnittlinie;
Fig. 2B einen Schnitt durch den in Fig. 1 dargestellten Aktorkörper des piezoelektrischen Aktors entlang der mit III bezeichneten Schnittlinie;
Fig. 3A und 3B schematische Darstellungen eines Spannungsverlaufs durch eine keramische Schicht eines Aktorkörpers eines piezoelektrischen Aktors ohne und mit einem Hohlraum;
Fig. 4 einen Schnitt durch den in Fig. 1 dargestellten Aktorkörper des piezoelektrischen Aktors entlang der mit IV bezeichneten Schnittlinie während der Herstellung;
Fig. 5 den in Fig. 1 mit V bezeichneten Ausschnitt eines piezoelektrischen Aktors in einer detaillierten Darstellung während des Herstellungsprozesses entsprechend einem ersten Ausführungsbeispiel;
Fig. 6 einen der Fig.4 entsprechenden Schnitt durch den in Fig. 1 dargestellten Aktorkörper des piezoelektrischen Aktors entsprechend einem zweiten Ausführungsbeispiel entlang der mit IV bezeichneten Schnittlinie;
Fig. 7 einen der Fig. 5 entsprechenden Ausschnitt eines piezoelektrischen Aktors vor einer Inbetriebnahme entsprechend einem dritten Ausführungsbeispiel der Erfindung und
Fig. 8 den in Fig. 7 mit VIII bezeichneten Ausschnitt des Aktorkörpers des piezoelektrischen Aktors entsprechend dem dritten Ausführungsbeispiel.

### Ausführungsformen der Erfindung

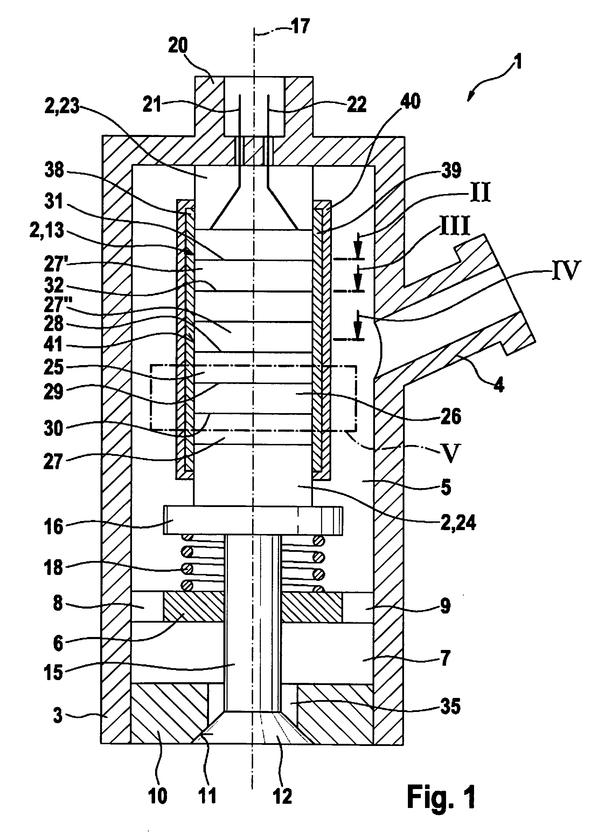

Fig. 1 zeigt ein Brennstoffeinspritzventil 1 mit einem piezoelektrischen Aktor 2 entsprechend einem Ausführungsbeispiel der Erfindung. Das Brennstoffeinspritzventil 1 kann als Injektor für Brennstoffeinspritzanlagen von luftverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist ein Ventilgehäuse 3 auf, an dem ein Brennstoffeinlassstutzen 4 ausgebildet ist. An den Brennstoffeinlassstutzen 4 ist eine Brennstoffleitung anschließbar, um Brennstoff von einer Hochdruckpumpe, beispielsweise über ein Common-Rail, in einen im Inneren des Ventilgehäuses 3 vorgesehenen Aktorraum 5 einzuleiten. Der Aktorraum 5 ist durch ein Gehäuseteil 6 begrenzt und von einem ebenfalls im Inneren des Ventilgehäuses 3 vorgesehenen Brennstoffraum 7 getrennt. In dem Gehäuseteil 6 sind Durchlassöffnungen 8, 9 ausgebildet, um den über den Brennstoffeinlassstutzen 4 in den Aktorraum 5 geführten Brennstoff in den Brennstoffraum 7 zu leiten.

An einem mit dem Ventilgehäuse 3 verbundenen Ventilsitzkörper 10 ist eine Ventilsitzfläche 11 ausgebildet, die mit einem Ventilschließkörper 12 zu einem Dichtsitz zusammenwirkt. Der Ventilschließkörper 12 ist mittels einer Ventilnadel 15 betätigbar, wobei in dem dargestellten Ausführungsbeispiel der Ventilschließkörper 12 einstückig mit der Ventilnadel 15 ausgebildet ist. Über die Ventilnadel 15 ist der Ventilschließkörper 12 mit einer im Aktorraum 5 vorgesehenen Druckplatte 16 verbunden. Das Gehäuseteil 6 führt die Ventilnadel 15 in Richtung einer Achse 17 des Brennstoffeinspritzventils 1. Ferner ist eine Ventilfeder 18 vorgesehen, die einerseits an dem Gehäuseteil 6 und andererseits an der Druckplatte 16 anliegt. Die Ventilfeder 18 beaufschlagt die Ventilnadel 15 mittels der Druckplatte 16 mit einer Schließkraft, so dass der zwischen dem Ventilschließkörper 12 und der Ventilsitzfläche 11 gebildete Dichtsitz geschlossen ist. Ferner erzeugt die Ventilfeder 18 eine gewisse Vorspannung des piezoelektrischen Aktors 2.

Außerdem ist an dem Ventilgehäuse 3 ein Anschlusselement 20 ausgebildet, um eine elektrische Zuleitung an das Brennstoffeinspritzventil 1 anzuschließen. Die elektrische Zuleitung kann dabei mittels eines Steckers an elektrische Leitungen 21, 22 des Brennstoffeinspritzventils 1 angeschlossen werden. Die elektrischen Leitungen 21, 22 sind durch das Ventilgehäuse 3 und ein an den Aktorkörper 13 des Aktors 2 angefügtes Übergangsstück 23, das als Aktorfuß 23 ausgestaltet ist, an den Aktorkörper 13 geführt. An den Aktorkörper 13 des Aktors 2 ist auf der Seite der Druckplatte 16 außerdem ein Übergangsstück 24 angefügt, das als Aktorkopf 24 ausgestaltet ist. Über den Aktorkopf 24 wirkt der Aktorkörper 13 entgegen der Kraft der Ventilfeder 18 auf die Druckplatte 16 ein.

Der Aktorkörper 13 des piezoelektrischen Aktors 2 weist eine Vielzahl von keramischen Schichten 25, 26, 27, 27', 27" und eine Vielzahl von zwischen den keramischen Schichten 25, 26, 27, 27', 27" angeordneten Elektrodenschichten 28, 29, 30, 31, 32 auf. Dabei sind zur Vereinfachung der Darstellung nur die keramischen Schichten 25, 26, 27, 27', 27" und die Elektrodenschichten 28, 29, 30, 31, 32 exemplarisch gekennzeichnet. Die Elektrodenschichten 28, 29 sind entweder mit der elektrischen Leitung 21 oder der elektrischen Leitung 22 verbunden. Beispielsweise ist ein Teil der Elektrodenschichten 28, 29, 30, 31, 32 mit der elektrischen Leitung 21 verbunden, um die positiven Elektroden zu bilden, und ein anderer Teil der Elektrodenschichten 28, 29, 30, 31, 32 mit der elektrischen Leitung 22 verbunden, um die negativen Elektroden zu bilden. Zur Verbindung der Elektrodenschichten 28, 29, 30, 31, 32 mit den elektrischen Leitungen 21, 22 dienen Außenelektroden 38, 39. Die Außenelektroden 38, 39 sind auf eine Oberfläche 41 des Aktorkörpers 13 aufgebracht. In diesem Ausführungsbeispiel ist die Oberfläche 41 durch eine Außenfläche 41 des Aktorkörpers 13 gebildet.

Über die elektrischen Leitungen 21, 22 kann der piezoelektrische Aktor 2 geladen und entladen werden. Beim Laden des Aktors 2 dehnt sich der Aktorkörper 13 in Richtung der Achse 17 aus, so dass der zwischen dem Ventilschließkörper 12 und der Ventilsitzfläche 11 gebildete Dichtsitz geöffnet wird. Dadurch kann Brennstoff aus dem Brennstoffraum 7 über einen Ringspalt 35 und den geöffneten Dichtsitz abgespritzt werden. Beim Entladen des Aktors 2 zieht sich der Aktorkörper 13 wieder zusammen, so dass der zwischen dem Ventilschließkörper 12 und der Ventilsitzfläche 11 ausgebildete Dichtsitz geschlossen ist.

Die Verbindung der elektrischen Leitungen 21, 22 mit den Elektrodenschichten 28, 29, 30, 31, 32 kann durch außenliegende oder innenliegende Elektrodenanbindungen erfolgen.

An den Aktorkörper 13 sind der Aktorfuß 23 und der Aktorkopf 24 angefügt. Dabei ist eine Ummantelung 40 vorgesehen, die den Aktorkörper 13 und jeweils teilweise den Aktorfuß 23 sowie den Aktorkopf 24 umgibt, um den piezoelektrischen Aktor 2 gegenüber dem Brennstoff im Aktorraum 5 zu schützen. Der Aktorkörper 13 weist zumindest die Oberfläche 41 auf. Die Außenfläche 41 des Aktorkörpers 13 stellt in diesem Ausführungsbeispiel die Oberfläche 41 dar. Der Aktorkörper 13 kann beispielsweise auch rohrförmig ausgestaltet sein, so dass neben der nach nach außen gerichteten Oberfläche 41 noch eine nach innen gerichtete Oberfläche vorgesehen ist.

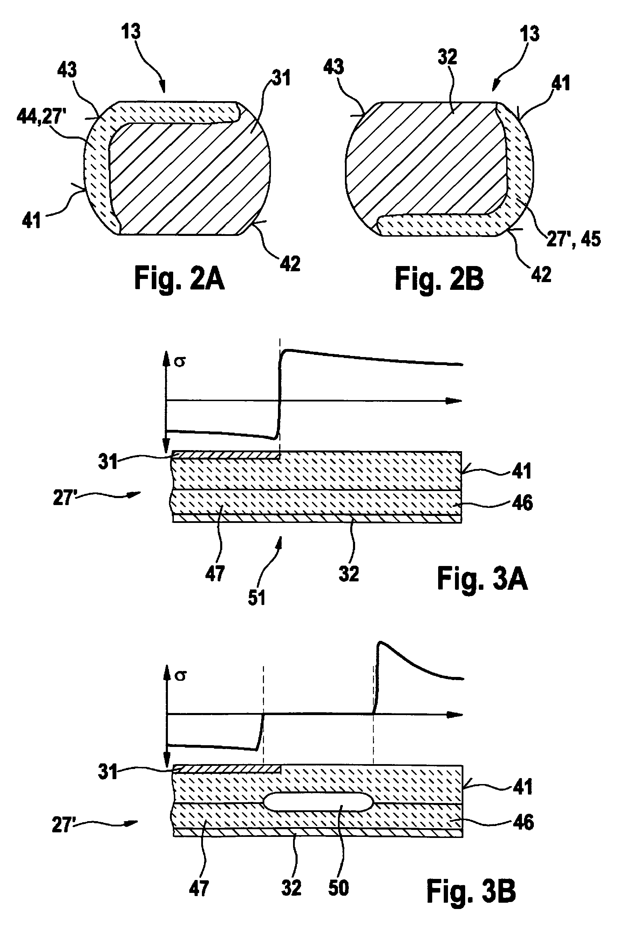

Die Ausgestaltung des piezoelektrischen Aktors des Brennstoffeinspritzventils 1 ist unter Bezugnahme auf die Fig. 2A und 2B im weiteren Detail beschrieben.

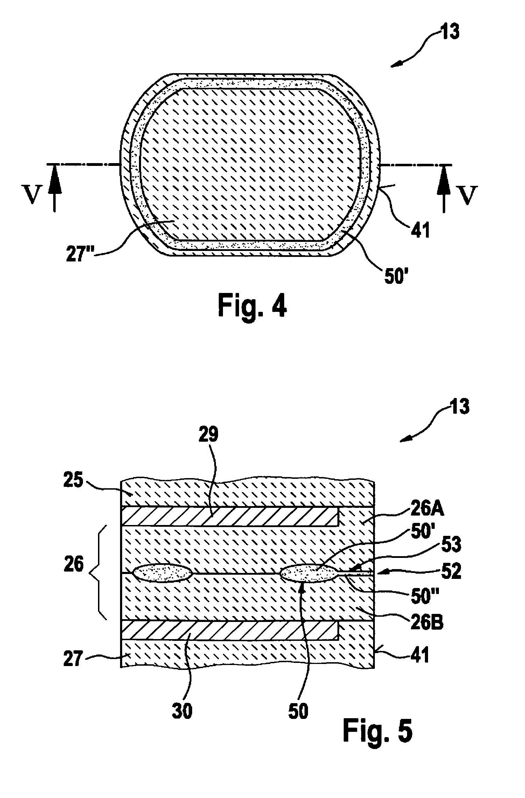

Fig. 2A zeigt einen Schnitt durch den in Fig. 1 gezeigten Aktorkörper 13 des piezoelektrischen Aktors 2 des Brennstoffeinspritzventils 1 entlang der mit II bezeichneten Schnittlinie und Fig. 2B zeigt einen Schnitt durch den Aktorkörper 13 entlang der mit III bezeichneten Schnittlinie. Die Fig. 2A zeigt dabei einen Schnitt durch die Elektrodenschicht 31 und die Fig. 2B zeigt einen Schnitt durch die Elektrodenschicht 32. Auf Grundlage der Nutzung des piezoelektrischen Verhaltens einiger Materialien ist es möglich, den piezoelektrischen Aktor aufzubauen, um beim Anlegen einer elektrischen Spannung zwischen die elektrischen Leitungen 21, 22 mechanische Arbeit zu verrichten. Da hierfür große elektrische Feldstärken benötigt werden, die von außen angelegte elektrische Spannung jedoch nach Möglichkeit klein gehalten werden soll, ist der Aktorkörper 13 des piezoelektrischen Aktors 2 vorzugsweise als Vielschichtbauteil aus dünnen Lagen keramischer Schichten 25, 26, 27, 27' mit den dazwischen liegenden Elektrodenschichten 28 bis 32 ausgeführt. Um das piezoelektrische Verhalten beispielsweise der keramischen Schicht 27' auszunutzen, müssen die angrenzenden Elektrodenschichten 31, 32 bei der Ansteuerung des piezoelektrischen Aktors 2 auf unterschiedlichen Potentialen liegen, insbesondere voneinander verschiedene Polaritäten aufweisen. Dies kann mit einem sogenannten Interdigitaldesign erreicht werden, bei dem an der Kontaktierungsstelle jeweils nur jede zweite Elektrodenschicht 31, 32 bis zur Oberfläche 41 des Aktorkörpers 13 geführt ist. In Bereichen des Aktorkörpers 13, in denen Elektrodenschichten 28, 29 zusammen geschaltet sind, wie es auch anhand der Fig. 5 beschrieben ist, kann sich kein elektrisches Feld aufbauen, so dass dort keine Polung erfolgt und dieser Bereich des Aktorkörpers 13, in diesem Fall die keramische Schicht 25, auch im Betrieb passiv bleibt.

Wie in den Fig. 2A und 2B gezeigt, sind die Elektrodenschichten 31, 32 nur teilweise bis an die Oberfläche 41 geführt, wobei der nicht von der Elektrodenschicht 31 beziehungsweise der Elektrodenschicht 32 eingenommene Teil des Querschnitts beispielsweise durch das piezokeramische Material der keramischen Schicht 27' aufgefüllt ist. Somit kann die Elektrodenschicht 31 beispielsweise in einem Bereich 42 an der Oberfläche 41 kontaktiert werden, während die Elektrodenschicht 32 in dem Bereich 42 nicht an die Oberfläche 41 geführt ist und somit nicht kontaktiert wird. Entsprechend kann die Elektrodenschicht 32 in einem Bereich 43 kontaktiert werden, in dem wiederum die Elektrodenschicht 31 nicht an die Oberfläche 41 geführt ist. Durch die keramische Schicht 27' ist somit in Bezug auf die Elektrodenschicht 31 eine Isolationszone 44 gebildet, während durch die keramische Schicht 27' in Bezug auf die Elektrodenschicht 32 eine Isolationszone 45 gebildet ist. Durch die Isolationszonen 44, 45 ergeben sich allerdings in Bezug auf die keramische Schicht 27' zwischen den Elektrodenschichten 31, 32 passive Bereiche 46 in der keramischen Schicht 27'. An den passiven Bereich 46 grenzt nämlich nur von einer Seite eine der Elektrodenschichten 31, 32 an, so dass bei einer Ansteuerung des piezoelektrischen Aktors 2 in dem passiven Bereich 46 kein elektrisches Feld hervorgerufen wird. Ferner weist die keramische Schicht 27' einen aktiven Bereich 47 auf, der von den Elektrodenschichten 31, 32 umgeben ist.

Fig. 3A und 3B zeigen Spannungsverläufe durch die keramische Schicht 27' bei unterschiedlicher Ausgestaltung des Aktorkörpers 13 im Bereich der keramischen Schicht 27'. Dabei ist im Unterschied zu der in Fig. 3A gezeigten Ausgestaltung bei der in Fig. 3B gezeigten Ausgestaltung ein Hohlraum 50 vorgesehen. Somit ist bei der in Fig. 3B gezeigten Ausgestaltung innerhalb des Aktorkörpers 13 zumindest ein Hohlraum 50 ausgebildet, der in diesem Fall weitgehend im Bereich des passiven Bereichs 46 der keramischen Schicht 27' angeordnet ist.

Fig. 3A zeigt einen Spannungsverlauf der Spannung 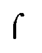 innerhalb der keramischen Schicht 27'. In einem Übergangsbereich 51 zwischen dem passiven Bereich 46 und dem aktiven Bereich 47 der keramischen Schicht 27' kommt es zu einem erheblichen Sprung in der Zugspannung 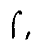 was die Ausbildung von Rissen in dem spröden Material der keramischen Schicht 27' begünstigt. Dabei ist in der Fig. 3A die mechanische Hauptspannung in Aktorrichtung entlang der Längsrichtung des Aktorkörpers 13, das heißt parallel zur Achse 17, dargestellt. Dabei geht die Zone der Druckspannung im aktiven Bereich 47 in eine Zone mit Zugspannung in den passiven Bereich 46 über. Es ist anzumerken, dass diese Spannungsprofile auch in weiteren keramischen Schichten, die entsprechend der keramischen Schicht 27' angesteuert sind, auftreten. Das exemplarisch in der Fig. 3 gezeigte Spannungsprofil resultiert aus den Dehnungsunterschieden zwischen dem aktiven Bereich 47 und dem passiven Bereich 46 bei der Ansteuerung des piezoelektrischen Aktors 2. Der dabei auftretende Spannungszustand des Aktorkörpers 13 kann in undefinierten Abständen zur Ausbildung von Entlastungsrissen führen, die unerwünscht sind. Denn diese Risse können zum Teil unkontrolliert in alle Raumrichtungen des Aktorkörpers 13 durch den Aktorkörper 13 verlaufen. Schneidet ein solcher Riss dabei zwei unterschiedlich gepolte Elektrodenschichten 31, 32, so kann es zu einem elektrischen Durchschlag und dadurch zu einer Schädigung der keramischen Schicht 27' kommen, was auch den Ausfall des gesamten piezoelektrischen Aktors 2 bedingen kann.

Durch die in der Fig. 3B gezeigte Ausgestaltung sind Zugspannungen im Bereich des Hohlraums 50 ganz abgebaut. Speziell kann durch die Kerbwirkung des Hohlraums 50 die Zugspannung in den passiven Bereich 46 verschoben werden, so dass sich Risse hauptsächlich ausgehend von dem Hohlraum 50 zur Oberfläche 41 bilden. Speziell Risse, die die beiden unterschiedlich gepolten Elektrodenschichten 31, 32 schneiden, sind dadurch verhindert.

Vorzugsweise sind mehrere Hohlräume 50 über den Aktorkörper 13 verteilt. Da sich die Zugspannungen in den vom Hohlraum 50 entfernten keramischen Schichten wieder aufbauen, kann durch die Wahl des Abstandes zwischen keramischen Schichten 27', die einen Hohlraum 50 aufweisen, die maximal auftretende Zugspannung bereichsweise gezielt auf ein für weitere Rissbildungen unkritisches Niveau reduziert werden.

Fig. 4 zeigt einen Schnitt durch den in Fig. 1 gezeigten Aktorkörper 13 eines piezoelektrischen Aktors 2 entlang der mit IV bezeichneten Schnittlinie während der Herstellung des piezoelektrischen Aktors 2. Der Schnitt verläuft dabei durch die keramische Schicht 27", in die eine Ausbrandstruktur 50' eingebracht ist. Während eines Sinterprozesses zur Herstellung des piezoelektrischen Aktors 2 brennt die Substanz der Ausbrandstruktur 50' aus, so dass ein Hohlraum entsprechend dem in Fig. 3B gezeigten Hohlraum 50 verbleibt. Die in Fig. 4 gezeigte Ausbrandstruktur weist dabei eine vorteilhafte Geometrie auf, um Risse zu initiieren, die im Wesentlichen von dem Hohlraum 50 ausgehen und zu der Oberfläche 41 führen.

Fig. 5 zeigt den in Fig. 1 mit V bezeichneten Ausschnitt eines Aktorkörpers 13 eines piezoelektrischen Aktors 2 entsprechend einem ersten Ausführungsbeispiel. Der dargestellte Ausschnitt enspricht dabei auch einem auszugsweisen Schnitt durch den in Fig. 4 dargestellten Aktorkörper 13 entlang der mit VI bezeichneten Schnittlinie.

In diesem Ausführungsbeispiel setzt sich die keramische Schicht 26 aus den Lagen 26A und 26B zusammen. Die Elektrodenschicht 29 ist auf die Lage 26A der keramischen Schicht 26 aufgebracht und die Elektrodenschicht 30 ist auf die Lage der keramischen Schicht 27 aufgebracht. Dabei sind die Elektrodenschichten 29, 30 im Unterschied zu den Elektrodenschichten 31, 32, die in den Fig. 2A und 2B dargestellt sind, zusammen geschaltet, so dass zwischen diesen im Betrieb des piezoelektrischen Aktors 2 zumindest im Wesentlichen kein elektrisches Feld ausgebildet ist. Ferner ist bei der Herstellung des piezoelektrischen Aktors 2 in die noch rohe Lage 26B der keramischen Schicht 26 eine Ausbrandstruktur 50' eingebracht, die einerseits von der Lage 26A und andererseits von der Lage 26B der keramischen Schicht 26 eingeschlossen ist. Ferner weist die keramische Schicht 26 eine Öffnung 52 an der Oberfläche 41 auf, über die die Substanz der Ausbrandstruktur 50' beim Ausbrennen abtransportiert wird. Zur Ausbildung der Öffnung 52 ist die Ausbrandstruktur 50' zumindest punktuell bis an die Oberfläche 41 geführt. Nach dem Ausbrennen hinterlässt die Ausbrandstruktur 50' den Hohlraum 50 innerhalb der keramischen Schicht 26. Somit ist in diesem Fall der Hohlraum 50 innerhalb der keramischen Schicht 26 vorgesehen. Es ist allerdings auch möglich, dass die Ausbrandstruktur 50' direkt an die Elektrodenschicht 29 angrenzt, so dass der Hohlraum 50 innerhalb des Aktorkörpers 13 teilweise durch die Elektrodenschicht 29 und teilweise durch die Lage 26B der keramischen Schicht 26 begrenzt ist.

Die in der Fig. 5 dargestellte Ausgestaltung hat den Vorteil, dass Risse in einem feldfreien Bereich, das heißt der keramischen Schicht 26 initiiert werden, so dass selbst im Fall von durch den Riss in die keramische Schicht 26 eindringenden Verunreinigungen sich diese elektrisch nicht schädlich auf die Funktionsweise des Aktorkörpers 13 auswirken.

Ferner ist in diesem Ausführungsbeispiel bei der Herstellung eine ringförmige Ausbrandstrucktur 50' mit näherungsweise elliptischem Ringquerschnitt vorgesehen. Dabei ist eine Ausbrandstruktur 50" auch in zumindest einem Ausbrandkanal 53 vorgesehen, um die Öffnung 52 zu bilden, über die die Substanz der Ausbrandstrukturen 50', 50" beim Ausbrennen abtransportiert wird.

Nach der Herstellung des Aktors 2 kann der Hohlraum 50 auch ganz oder teilweise mit einer porösen keramischen Struktur 50' gefüllt sein. Solch eine als Füllung oder Teilfüllung für den Hohlraum 50 dienende poröse keramische Struktur 50' wirkt sich positiv auf ein mögliches Rissverhalten im Aktorkörper 13 aus.

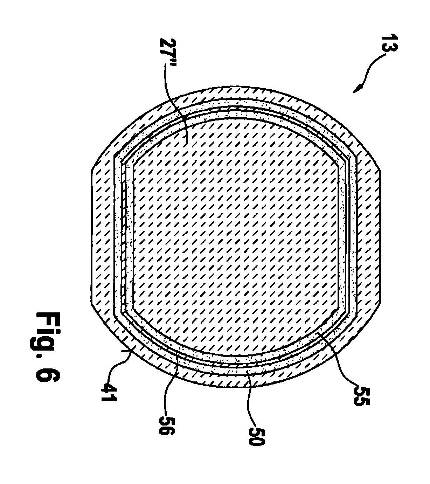

Fig. 6 zeigt einen der Fig.4 entsprechenden Schnitt durch den in Fig. 1 dargestellten Aktorkörper 13 des piezoelektrischen Aktors 2 entsprechend einem zweiten Ausführungsbeispiel entlang der mit IV bezeichneten Schnittlinie. Der Schnitt lauft dabei durch eine Querschnittsebene des Aktors 2, die senkrecht zu der Achse 17 orientiert ist.

Innerhalb des Aktorkörpers 13 sind ein erster Hohlraum 50 und ein zweiter Hohlraum 55 ausgebildet, die in der Querschnittsebene liegen. Der erste Hohlraum 50 ist von dem zweiten Hohlraum 55 durch einen keramischen Bereich 56 der keramischen Schicht 27" getrennt. Durch diese zwei voneinander getrennten Geometrien, die in einer Ebene, nämlich der in der Fig. 6 gezeigten Querschnittsebene, liegen, kann erreicht werden, dass entstehende Risse effektiv in eine gewünschte Richtung und Ebene gelenkt werden und weniger dazu neigen, sich zu verzweigen, beziehungsweise dass der Rissfortlauf definiert gestoppt wird. Zusätzlich bietet der tragende keramische Bereich 56 zwischen den zwei die Hohlräume 55, 56 erzeugenden Geometrien den Vorteil, dass eine Steifigkeit des Aktors 2 im Vergleich zu einem entsprechendem einzelnen Hohlraum erhöht ist.

Der keramische Bereich 56 ist ist in diesem Ausführungsbeispiel als tragender keramischer Bereich 56 ausgestaltet. Der keramische Bereich 56 kann im allgemeinen eine weitgehend beliebige Ausgestaltung, insbesondere Größe, haben. In diesem Ausführungsbeispiel ist der keramische Bereich 56 als keramischer Steg 56 zwischen den Hohlräumen 50, 55 ausgestaltet. Ferner sind die Hohlräume 50, 56 ringförmig ausgestaltet sind, wobei der ringförmige zweite Hohlraum 55 innerhalb des ringförmigen ersten Hohlraums 50 angeordnet ist.

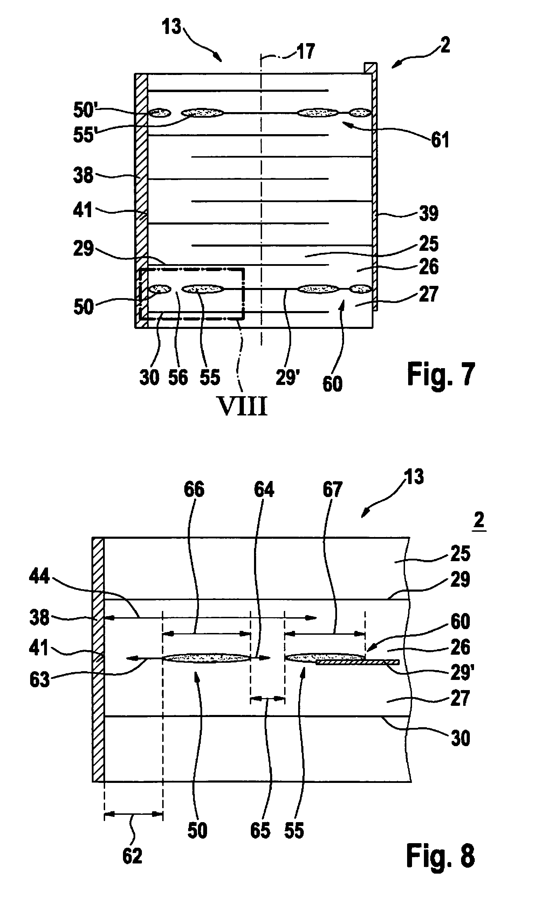

Fig. 7 zeigt einen der Fig. 5 entsprechenden Ausschnitt eines Aktorkörpers 13 des piezoelektrischen Aktors 2 entsprechend einem dritten Ausführungsbeispiel. In diesem Ausführungsbeispiel sind Ausbrandstrukturen 60, 61 über den Aktorkörper 13 verteilt. Die Ausbrandstruktur 60 weist einen ersten Hohlraum 50 und einen zweiten Hohlraum 55 auf. Die Hohlräume 50, 55 liegen dabei zumindest näherungsweise in einer Querschnittsebene, die senkrecht zu einer Achse 17 des Aktorkörpers 13 orientiert ist. Die Hohlräume 50, 55 sind dabei jeweils ringförmig ausgestaltet, wobei sich eine Anordnung ergibt, die entsprechend in der Fig. 6 veranschaulicht ist. Allerdings ist ein keramischer Bereich 56 zwischen den Hohlräumen 50, 55 in diesem Ausführungsbeispiel nicht als tragender keramischer Bereich ausgestaltet. Der erste Hohlraum 50 liegt näher an der Oberfläche 41 als der zweite Hohlraum 55.

Entsprechend ist auch die Ausbrandstruktur 61 mit den Hohlräumen 50', 55' ausgestaltet.

In diesem Ausführungsbeispiel grenzt der zweite Hohlraum 55 außerdem an eine Elektrodenschicht 29' an. Hierbei ist eine Situation veranschaulicht, bei der die Ausbrandstrukturen 60, 61 in einem aktiven Bereich des Aktorkörpers 13 angeordnet sein können. Entsprechendes gilt für die Hohlräume 50', 55', die ebenfalls in einem aktiven Bereich des Aktorkörpers 13 angeordnet sein können.

Die Ausgestaltung des Aktorkörpers 13 des piezoelektrischen Aktors 2 des dritten Ausführungsbeispiels ist im Folgenden auch unter Bezugnahme auf die Fig. 8 im weiteren Detail beschrieben.

Fig. 8 zeigt den in Fig. 7 mit VIII bezeichneten Ausschnitt des Aktorkörpers 13 des piezoelektrischen Aktors 2. Die Ausbrandstruktur 60 ist in diesem Ausführungsbeispiel nach der Herstellung des Aktorkörpers 13 nicht mit der Oberfläche 41 verbunden. Somit ist die Ausbrandstruktur 60 von außen nach der Prozessierung des Aktors nicht zugänglich. Die Ausbrandstruktur 60 dieses Ausführungsbeispiels ermöglicht die Entstehung von Rissen während des Betriebs des piezoelektrischen Aktors 2. In diesem Ausführungsbeispiel kann die Ausbrandstruktur 60 direkt auf die Elektrode 29 gedruckt werden. Die darauf folgende Elektrode 29 ist entgegengesetzt zu der Elektrode 29' gepolt. Die Ausbrandstruktur 60 ist hierbei in der Nähe der Elektrode 29' und zwischen den Elektroden 29, 29' angeordnet. Hierdurch kann eine Rissauslösung im felddurchsetzten Bereich erfolgen und ein Hubverlust im Vergleich zu einem piezoelektrischen Aktor mit gleicher Schichtanzahl ohne eine solche Ausbrandstruktur 60 verhindert werden. Die Anzahl der über den Aktorkörper 13 verteilten Ausbrandstrukturen 60, 61 ist größer als eine vorgegebene minimale Anzahl, die so gewählt ist, dass keine zusätzlichen natürlichen Risse während des Betriebs mehr entstehen können. Ferner ist die Anzahl der Ausbrandstrukturen 60, 61 kleiner als eine maximale Anzahl, die so vorgegeben ist, dass bei dieser maximalen Anzahl ein zuverlässiges Aufreißen aller Ausbrandstrukturen 60, 61 im Betrieb noch gewährleistet ist.

Die Ausbrandstrukturen 60, 61 können beispielsweise in einer Siebdrucktechnik hergestellt werden. Hierbei ist ein mittlerer Abstand 62 der Ausbrandstruktur 60 von der Oberfläche 41, d.h. in diesem Fall ein mittlerer Abstand 62, so kurz wie möglich gewählt. Dabei ermöglicht der Abstand 62 ein sicheres Aufreißen des Hohlraums 50 im Betrieb. Das heißt, es wird eine gezielte Ausbildung 63 eines Risses 63, 64 von dem Hohlraum 50 zu der Oberfläche 41 gewährleistet. Der Abstand 62 ist dabei allerdings groß genug, um ein Öffnen des Hohlraums 50 nach dem Schleifen, vor der Inbetriebnahme zu verhindern. Bei der Inbetriebnahme reißt der Hohlraum 50 zu der Oberfläche 41 hin auf, wodurch die gezielte Ausbildung 63 des Risses 63, 64 erfolgt. Hierbei kann es allerdings auch zu einer zusätzlichen Ausdehnung 64 des Risses 63, 64 in das Innere des Aktorkörpers 13 kommen. Der zweite Hohlraum 55 ist innerhalb des ersten Hohlraums 50 angeordnet, so dass diese zusätzliche Ausdehnung 64 des Risses 63, 64 zu dem zweiten Hohlraum 55 hin erfolgt. Der zweite Hohlraum 55 dient zum Stoppen dieser zusätzlichen Ausdehnung 64 des Risses 63, 64. Dadurch wird verhindert, dass der Riss 63, 64 in den aktiven Bereich des Aktorkörpers 13 hineinläuft. Ein Abstand 65 zwischen den Hohlräumen 50, 55 ist gerade so groß vorgegeben, dass die zusätzliche Ausdehnung 64 des Risses 63, 64 sicher gestoppt wird und nicht weiter in den aktiven Bereich hineinläuft.

Aufgrund der erforderlichen Isolationszone 44 zwischen der als Innenelektrode dienenden Elektrodenschicht 29' und der Außenelektrode 38 ist das Abdecken des gesamten Bereichs mit einer nur einen Hohlraum bildenden Ausbrandstruktur gegebenenfalls nicht ausreichend, so dass eine Ausbrandstruktur 60 mit zwei oder mehr Hohlräumen 50, 55 erforderlich ist. Im Querschnitt betrachtete Breiten 66, 67 der Hohlräume 50, 55 können gleich groß oder unterschiedlich groß gewählt sein. Dabei können der Abstand 62 der Ausbrandstruktur 60 von der Oberfläche 41, die Breite 66 des ersten Hohlraums 50, der Abstand 65 der beiden Hohlräume 50, 55 voneinander und die Breite 67 des zweiten Hohlraums 55 jeweils aus einem Bereich von etwa 100 µm bis etwa 500 µm vorgegeben sein.

Somit ist eine vorteilhafte Herstellung und Bearbeitung des Aktorkörpers 13 bzw. des piezoelektrischen Aktors 2 möglich. Bei der Inbetriebnahme des piezoelektrischen Aktors 2 kommt es zu der gezielten Ausbildung 63 des Risses 63, 64. Der innere Hohlraum 55 kann dabei zur Richtungsvorgabe für eine zusätzliche Ausdehnung 64 des Risses 63, 64 und für den Stopp der Rissausbreitung in Richtung des aktiven Aktorbereichs dienen.

Die beschriebene Doppelring-Struktur der Hohlräume 50, 51 ermöglicht eine relativ große Breite der Isolationszone 44, das heißt einen großen Abstand zwischen der Elektrodenschicht 29' und der Außenelektrode 38. Hierbei können Einbrüche in der Ausbrandstruktur 60 verhindert werden, wodurch die gewünschte Spannungsverteilung, die im Aktorkörper 13 zu einer gezielten Rissbildung führt, günstig beeinflusst ist.

Entsprechende Vorteile können in Bezug auf die Außenelektrode 39 erzielt werden.

Die Erfindung ist nicht auf die beschriebenen Ausführungsbeispiele beschränkt.

## Patentansprüche

1. Piezoelektrischer Aktor (2), insbesondere Stapelaktor für Brennstoffeinspritzventile, mit einem Aktorkörper (13), der eine Vielzahl von keramischen Schichten (25, 26, 27, 27', 27") und eine Vielzahl von zwischen den keramischen Schichten angeordneten Elektrodenschichten (28, 29, 30, 31, 32) aufweist, wobei innerhalb des Aktorkörpers (13) ein erster Hohlraum (50) und ein zweiter Hohlraum (55) ausgebildet sind, die zumindest näherungsweise in einer Querschnittsebene liegen, und dass der erste Hohlraum (50) von dem zweiten Hohlraum (55) zumindest vor einer Inbetriebnahme durch einen keramischen Bereich (56) der keramischen Schicht (27") getrennt ist, **dadurch gekennzeichnet,**
**dass** der erste Hohlraum (50) ringförmig ausgestaltet ist, dass der zweite Hohlraum (55) ringförmig ausgestaltet ist und dass der ringförmige zweite Hohlraum (55) innerhalb des ringförmigen ersten Hohlraums (50) angeordnet ist.

2. Piezoelektrischer Aktor nach Anspruch 1,
**dadurch gekennzeichnet,**
**dass** zumindest ein Hohlraum (50, 55) innerhalb des Aktorkörpers (13) teilweise durch eine Elektrodenschicht (29) und teilweise durch eine keramische Schicht (26) begrenzt ist.

3. Piezoelektrischer Aktor nach Anspruch 1,
**dadurch gekennzeichnet,**
**dass** Spannungsrisse innerhalb des Aktorkörpers (13) zumindest im Wesentlichen von dem ersten (50) oder dem zweiten Hohlraum (55) ausgehen.

4. Piezoelektrischer Aktor nach Anspruch 3,
**dadurch gekennzeichnet,**
**dass** die Hohlräume (50, 55) zwischen zwei elektrisch gleichgeschalteten Elektrodenschichten (29, 30) vorgesehen sind.

5. Piezoelektrischer Aktor nach einem der Ansprüche 1 bis 4, **dadurch gekennzeichnet, dass** die Hohlräume (50, 55) als zumindest teilweise ausgebrannte Hohlräume (50, 55) ausgebildet sind.

6. Piezoelektrischer Aktor nach einem der Ansprüche 1 bis 5, **dadurch gekennzeichnet, dass** die Hohlräume (50, 55) zumindest teilweise mit einer porösen keramischen Struktur (50') gefüllt sind.

7. Piezoelektrischer Aktor nach Anspruch 5 oder 6,
**dadurch gekennzeichnet,**
**dass** der Aktorkörper (13) zumindest eine Öffnung (52) aufweist, über die der erste Hohlraum (50) mit einer Umgebung des Aktorkörpers (13) verbunden ist.

8. Piezoelektrischer Aktor nach einem der Ansprüche 1 bis 7,
**dadurch gekennzeichnet,**
**dass** mehrere Hohlräume (50, 55) innerhalb des Aktorkörpers (13) vorgesehen sind, die gleichmäßig oder in variierenden Abständen über den Aktorkörper (13) verteilt sind.

9. Piezoelektrischer Aktor nach einem der Ansprüche 1 bis 8,
**dadurch gekennzeichnet,**
**dass** der keramische Bereich (56) der keramischen Schicht (27") als tragender keramischer Bereich (56) ausgestaltet ist.

10. Piezoelektrischer Aktor nach einem der Ansprüche 1 bis 9,
**dadurch gekennzeichnet,**
**dass** der erste Hohlraum (50) näher an der Oberfläche (41) angeordnet ist als der zweite Hohlraum (55), dass der erste Hohlraum (50) die gezielte Ausbildung (63) des Risses (63, 64) von dem ersten Hohlraum (50) zu der Oberfläche (41) ermöglicht und dass der zweite Hohlraum (55) bei der gezielten Ausbildung des Risses (63, 64) von dem ersten Hohlraum (50) zu der Oberfläche (41) zum Stoppen einer möglichen zusätzlichen Ausdehnung (64) des Risses (63, 64) in eine keramische Schicht (27") dient.

11. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 10 und einem von dem Aktor (2) betätigbaren Ventilschließkörper (12), der mit einer Ventilsitzfläche (11) zu einem Dichtsitz zusammenwirkt.

## Claims

1. Piezoelectric actuator (2), in particular stack actuator for fuel injection valves, having an actuator body (13) which has a multiplicity of ceramic layers (25, 26, 27, 27', 27'') and a multiplicity of electrode layers (28, 29, 30, 31, 32) arranged between the ceramic layers, wherein there are formed within the actuator body (13) a first cavity (50) and a second cavity (55) which lie at least approximately in one cross-sectional plane, and wherein the first cavity (50) is separated from the second cavity (55) at least before initial operation by a ceramic region (56) of the ceramic layer (27''),
**characterized**
**in that** the first cavity (50) is of annular design, in that the second cavity (55) is of annular design and in that the annular second cavity (55) is arranged within the annular first cavity (50).

2. Piezoelectric actuator according to Claim 1,
**characterized**
**in that** at least one cavity (50, 55) within the actuator body (13) is delimited partially by an electrode layer (29) and partially by a ceramic layer (26).

3. Piezoelectric actuator according to Claim 1,
**characterized**
**in that** stress cracks within the actuator body (13) proceed at least substantially from the first (50) or the second cavity (55).

4. Piezoelectric actuator according to Claim 3,
**characterized**
**in that** the cavities (50, 55) are provided between two electrode layers (29, 30) of the same electrical polarity.

5. Piezoelectric actuator according to one of Claims 1 to 4, **characterized in that** the cavities (50, 55) are formed as at least partially burned-out cavities (50, 55).

6. Piezoelectric actuator according to one of Claims 1 to 5, **characterized in that** the cavities (50, 55) are at least partially filled with a porous ceramic structure (50').

7. Piezoelectric actuator according to Claim 5 or 6,
**characterized**
**in that** the actuator body (13) has at least one opening (52) via which the first cavity (50) is connected to surroundings of the actuator body (13).

8. Piezoelectric actuator according to one of Claims 1 to 7,
**characterized**
**in that** multiple cavities (50, 55) are provided within the actuator body (13) and are distributed uniformly or at varying intervals over the actuator body (13).

9. Piezoelectric actuator according to one of Claims 1 to 8,
**characterized**
**in that** the ceramic region (56) of the ceramic layer (27") is formed as a supporting ceramic region (56).

10. Piezoelectric actuator according to one of Claims 1 to 9,
**characterized**
**in that** the first cavity (50) is arranged closer to the surface (41) than the second cavity (55), in that the first cavity (50) permits the targeted formation (63) of the crack (63, 64) from the first cavity (50) to the surface (41), and in that the second cavity (55) serves, in the case of the targeted formation of the crack (63, 64) from the first cavity (50) to the surface (41), to stop a possible additional propagation (64) of the crack (63, 64) into a ceramic layer (27'').

11. Fuel injection valve (1), in particular injector for fuel injection systems of air-compressing, autoignition internal combustion engines, having a piezoelectric actuator (2) according to one of Claims 1 to 10, and having a valve closing body (12) which can be actuated by the actuator (2) and which interacts with a valve seat surface (11) to form a sealing seat.

## Revendications

1. Actionneur piézoélectrique (2), en particulier empilement d'actionneur pour soupapes d'injection de carburant, présentant un corps d'actionneur (13) doté de plusieurs couches céramiques (25, 26, 27, 27', 27") et de plusieurs couches d'électrode (28, 29, 30, 31, 32) disposées entre les couches céramiques,
une première cavité (50) et une deuxième cavité (55) situées au moins approximativement dans un plan de section transversale sont formées à l'intérieur du corps d'actionneur (13),
la première cavité (50) étant au moins avant la mise en service séparée de la deuxième cavité (55) par une partie céramique (56) de la couche céramique (27"),
**caractérisé en ce que**
la première cavité (50) a une configuration annulaire,
**en ce que** la deuxième cavité (55) a une configuration annulaire et **en ce que**
la deuxième cavité annulaire (55) est disposée à l'intérieur de la première cavité annulaire (50).

2. Actionneur piézoélectrique selon la revendication 1, **caractérisé en ce qu'**au moins une cavité (50, 55) est délimitée à l'intérieur du corps d'actionneur (13) en partie par une couche d'électrode (29) et en partie par une couche céramique (26).

3. Actionneur piézoélectrique selon la revendication 1, **caractérisé en ce que** les fissurations sous contrainte à l'intérieur du corps d'actionneur (13) se propagent au moins essentiellement depuis la première cavité (50) ou depuis la deuxième cavité (55).

4. Actionneur piézoélectrique selon la revendication 3, **caractérisé en ce que** les cavités (50, 55) sont prévues entre deux couches d'électrode (29, 30) raccordées au même potentiel électrique.

5. Actionneur piézoélectrique selon l'une des revendications 1 à 4, **caractérisé en ce que** les cavités (50, 55) sont configurées comme cavités (50, 55) au moins en partie par combustion.

6. Actionneur piézoélectrique selon l'une des revendications 1 à 5, **caractérisé en ce que** les cavités (50, 55) sont remplies au moins en partie d'une structure céramique poreuse (50').

7. Actionneur piézoélectrique selon les revendications 5 ou 6, **caractérisé en ce que** le corps d'actionneur (13) présente au moins une ouverture (52) par laquelle la première cavité (50) est reliée à l'environnement du corps d'actionneur (13).

8. Actionneur piézoélectrique selon l'une des revendications 1 à 7, **caractérisé en ce que** plusieurs cavités (50, 55) sont prévues à l'intérieur du corps d'actionneur (13) et sont réparties régulièrement ou à intervalles variables dans le corps d'actionneur (13).

9. Actionneur piézoélectrique selon l'une des revendications 1 à 8, **caractérisé en ce que** la partie céramique (56) de la couche céramique (27") est configurée comme partie céramique portante (56).

10. Actionneur piézoélectrique selon l'une des revendications 1 à 9, **caractérisé en ce que** la première cavité (50) est disposée plus près de la surface (41) que la deuxième cavité (55), **en ce que** la première cavité (50) permet la formation contrôlée (63) d'une fissuration (63, 64) entre la première cavité (50) et la surface (41) et **en ce que** lors de la formation contrôlée de la fissuration (63, 64) entre la première cavité (50) et la surface (41), la deuxième cavité (55) sert à bloquer une poursuite éventuelle de la propagation (64) de la fissuration (63, 64) dans une couche céramique (27'').

11. Soupape (1) d'injection de carburant, en particulier injecteur pour installations d'injection de carburant de moteur à combustion interne à autoallumage et compression d'air, la soupape présentant un actionneur piézoélectrique (2) selon l'une des revendications 1 à 10 et un corps (12) de fermeture de soupape qui peut être actionné par l'actionneur (2) et qui coopère avec une surface (11) de siège de soupape pour former un siège étanche.
